# EUROPEAN PATENT APPLICATION

(11) **EP 1 703 779 A1**
(43) Date of publication of application: **20.09.2006**
(21) Application number: 06251273.6
(22) Date of filing: 09.03.2006
(51) Int. Cl.: H05K 1/02, H05K 1/14

(54) **Electronic equipment provided with circuit substrate**

(30) Priority: 14.03.2005 JP 2005071915
(71) Applicant: ORION ELECTRIC CO., Ltd., Fukui 915-8555 (JP)
(72) Inventor: Tokuda, Takashi c/o IPD., Orion Electric Co., Ltd., Fukui 915-8555 (JP)
(74) Representative: Paget, Hugh Charles Edward

(57) **Abstract**

To provide a circuit substrate made up of a main circuit substrate section and a split substrate section detachable from the main circuit substrate section which makes it possible to select whether or not the split substrate section can be separated and also connect these sections a simple and reliable manner. Connection sections 20, 21 to which jumper lines 10 and connectors 16 can be commonly connected are formed in circuit patterns 2, 15 of each section 1, 8. In this way, when the split substrate section 8 is detached from the main circuit substrate section 1 and then reconnected to the main circuit substrate section 1, these sections 1, 8 are connected by the connectors 16. On the other hand, when the split substrate section 8 is left united with the main circuit substrate section 1, these sections 1, 8 can be connected using the jumper lines 10.

## Description

### BACKGROUND OF THE INVENTION

### Field of the Invention

The present invention relates to electronic equipment provided with a circuit substrate placed in an enclosure, on which an electronic part is mounted, and more particularly, to a circuit substrate provided with a split substrate section which is detachable from a main circuit substrate section provided for electronic equipment for which it is possible to select any one of a specification whereby the split substrate section is detached from the main circuit substrate section and a specification whereby the main circuit substrate section and split substrate section are united.

### Description of the Related Art

A circuit substrate mounted with many electronic parts including a tuner is generally placed inside electronic equipment such as a television receiver, and in recent years, there are an increasing number of cases where the step of mounting parts on the circuit substrate and the step of assembling finished products in manufacturing processes of this type of electronic equipment are performed in different factories. Therefore, when a mounting substrate is assembled and transported to a factory, it is necessary to divide the mounting substrate, reduce its packing size and reduce costs for the purpose of a cost reduction during transportation.

Thus, in order to meet this demand, Japanese Patent Laid-Open Publication No.2003-218477 (Patent Document 1) discloses a circuit substrate to be placed in electronic equipment, provided with a split section made up of perforation holes and grooves, making the substrate detachable from this split section.

However, the circuit substrate shown in Patent Document 1 connects the circuit substrate and the split substrate using jumper lines, folds, when the split substrate is detached from the circuit substrate, the jumper lines substantially at right angles and attaches the split substrate to the circuit substrate so as to cross each other at right angles, and is thereby intended to provide a certain degree of freedom in physical motion between the substrates and provide a circuit substrate which can be easily operated when the substrate is divided, folded or positioned. Since the circuit substrate and split substrate are connected by the jumper lines, the split substrate cannot be completely detached from the circuit substrate. For this reason, it has been impossible to mount dimensionally high-profile parts or bulky electronic parts on a split substrate detachable from the circuit substrate, separate the split substrate mounted with the electronic part from the circuit substrate and reconnect the circuit substrate and the split substrate at an assembly plant or the like. That is, in order to reduce transportation cost, when the split substrate is detached from the circuit substrate and the circuit substrate and split substrate are then reconnected, it is more convenient to connect the circuit substrate and the split substrate using detachable connectors. On the other hand, when all steps from the manufacturing of the substrate to its assembly into the enclosure are performed in the same factory, it is more convenient not to separate the split substrate from the circuit substrate and leave them united instead. In this case, connecting the circuit substrate and the split substrate using the jumper lines described in Patent Reference 1 is easier from the standpoints of cost as well as manufacturing processing. However, the circuit substrate in above described Patent Reference 1 uses the jumper lines as the means for connecting the circuit substrate and split substrate, and therefore it is difficult to select connectors or jumper lines to connect the circuit substrate and the split substrate as required.

### SUMMARY OF THE INVENTION

The present invention has been implemented in view of the above described problems and it is an object of the present invention to provide electronic equipment provided with a circuit substrate including a split substrate which is detachable from a main circuit substrate section, capable of selecting whether or not to separate the split substrate and easily and reliably connecting the main circuit substrate section and the split substrate regardless of whether or not the split substrate is separated.

The electronic equipment provided with a circuit substrate according to a first aspect is electronic equipment provided with a circuit substrate placed in an enclosure, on which an electronic part is mounted, the circuit substrate comprising a main circuit substrate section and a split substrate section which is detachable from the main circuit substrate section, wherein the split substrate section is made detachable from the main circuit substrate section as required, when the split substrate section is used united as the circuit substrate without being separated, the split substrate section and the main circuit substrate section are electrically connected using a jumper lines, when the split substrate section is used detached from the main circuit substrate section, connectors which are freely attachable/detachable to/from the circuit substrate section and the split substrate section are inserted, both connectors are electrically connected by a cable, and the circuit substrate section and the split substrate section are provided with a circuit pattern common to the connectors and the jumper lines.

According to the construction of the first aspect, when, for example, manufacturing and assembly of a substrate need to be performed in different factories, the split substrate section is detached from the main circuit substrate section and the main circuit substrate section and split substrate section are connected through detachable connectors. On the other hand, when all steps from manufacturing to assembly of the substrate are performed in the country, it is possible to electrically connect the main circuit substrate section and split substrate section as one piece without separating the split substrate section from the main circuit substrate section.

The electronic equipment provided with a circuit substrate according a second aspect is the electronic equipment provided with a circuit substrate according to the first aspect, wherein a split section made up of holes of perforations and grooves is formed on a boundary between the main circuit substrate section and split substrate section, a plurality of mutually facing split sections provided with at least the common circuit pattern arranged on the boundary between the main circuit substrate section and split substrate section are formed, and when the split substrate section is separated, a part surrounded by the facing split sections constitutes an expendable section which can be separated.

According to the construction of the second aspect, a fully detachable expendable are is provided in the split section made up of holes of perforations and grooves, and when the main circuit substrate section and split substrate section are divided and separated apart, the area surrounded by the split section is detached to form a wide space corresponding to an expendable area on a boundary between the main circuit substrate section and split substrate section, and when the split substrate section is detached from the main circuit substrate section and then reconnected to the main circuit substrate section through connectors, it is possible to prevent irregular projections and depressions formed on cut-out sections when the split substrate section is divided from touching each other. This makes it possible to place the split substrate section in the original position accurately and there is no difference in the position of the split substrate with respect to the circuit substrate when the split substrate section is separated and when the split substrate section is not separated but left united with the main circuit substrate section.

The electronic equipment provided with a circuit substrate according to a third aspect is the electronic equipment provided with a circuit substrate according to the first or second aspect, wherein the circuit substrate is placed in an enclosure of a television receiver, a tuner is mounted on the split substrate section as an electronic part, and the tuner is electrically connected to the circuit pattern of the main circuit substrate section through the jumper lines or connectors.

According to the construction of the third aspect, a tuner having a relatively high profile is mounted on the split substrate section, if the split substrate section mounted with a tuner is divided, it is possible to reduce the thickness of the main circuit substrate section during transportation, and for assembly of the circuit substrate, it is possible to connect the tuner and the main circuit substrate section through connectors when the split substrate section is separated or using jumper lines when the split substrate section need not be divided.

### BRIEF DESCRIPTION OF THE DRAWINGS

FIG. 1 is a plan view of a circuit substrate showing an embodiment of the present invention, showing a split substrate section not detached.
FIG. 2 is an enlarged plan view of a connection section between the main circuit substrate section and the split substrate section according to an embodiment of the present invention.
FIG.3 is a plan view of the circuit substrate showing the main circuit substrate section and split substrate section according to an embodiment of the present invention connected using jumper lines.
FIG.4 is a plan view showing the split substrate section detached from the main circuit substrate section according to an embodiment of the present invention.
FIG.5 is a perspective view of the circuit substrate showing the connection between the split substrate section and the main circuit substrate section according to an embodiment of the present invention.
FIG.6 are enlarged views of the split section according to an embodiment of the present invention; FIG. 6(a) showing the split section before being detached and FIG. 6(b) showing the split section after being detached.
FIG.7 is a plan view of the circuit substrate showing the connection between the split substrate section and the main circuit substrate section according to an embodiment of the present invention.
FIG.8 is a rear view of a television receiver showing the mounting condition of the circuit substrate in an enclosure.

### DETAILED DESCRIPTION OF THE PREFERRED EMBODIMENTS

Hereinafter, an embodiment as the best mode of implementing the present invention will be explained with reference to the attached drawings. It goes without saying that the present invention is also readily applicable to configurations other than those explained in this embodiment without departing from the essence of the present invention.

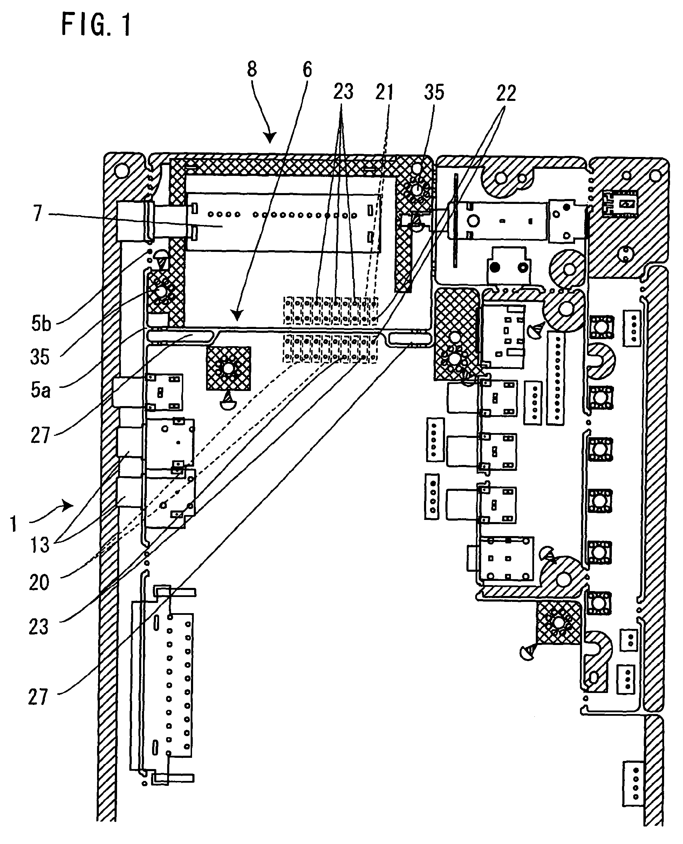

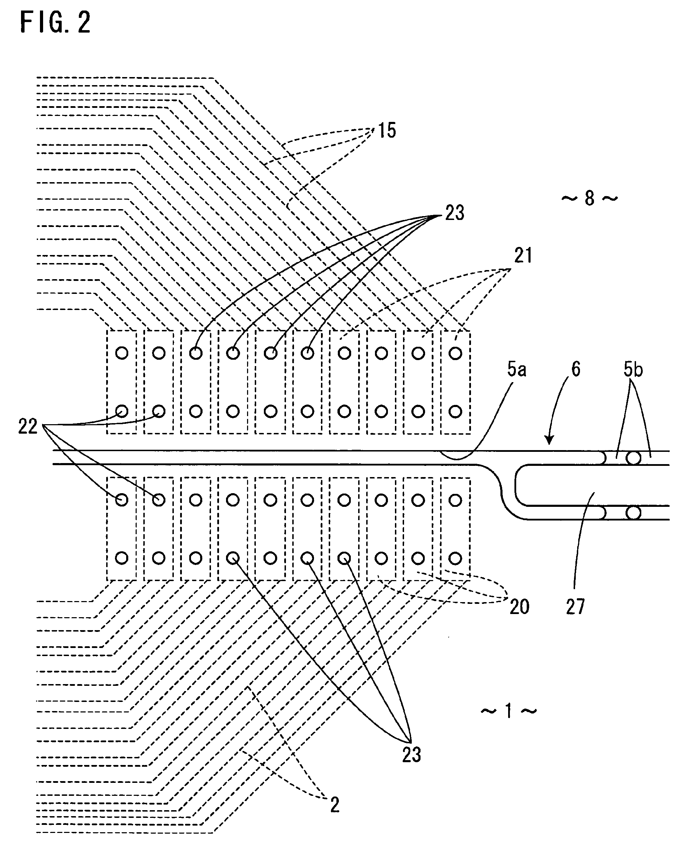

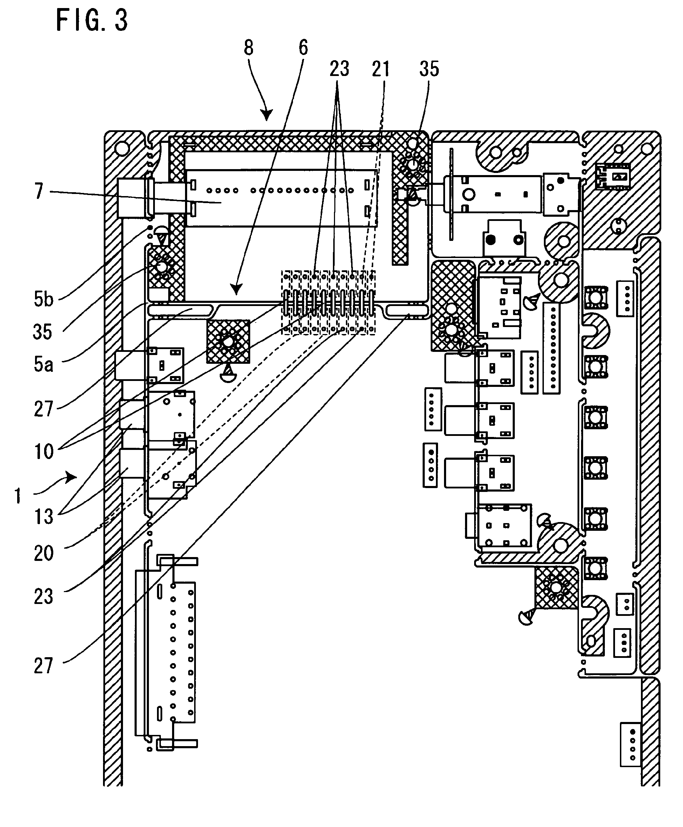

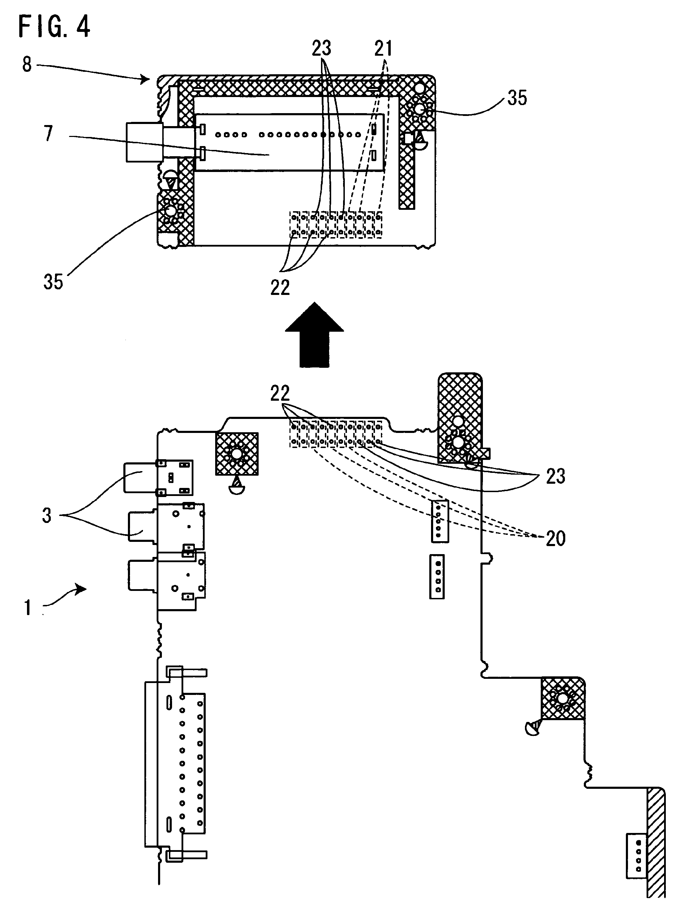

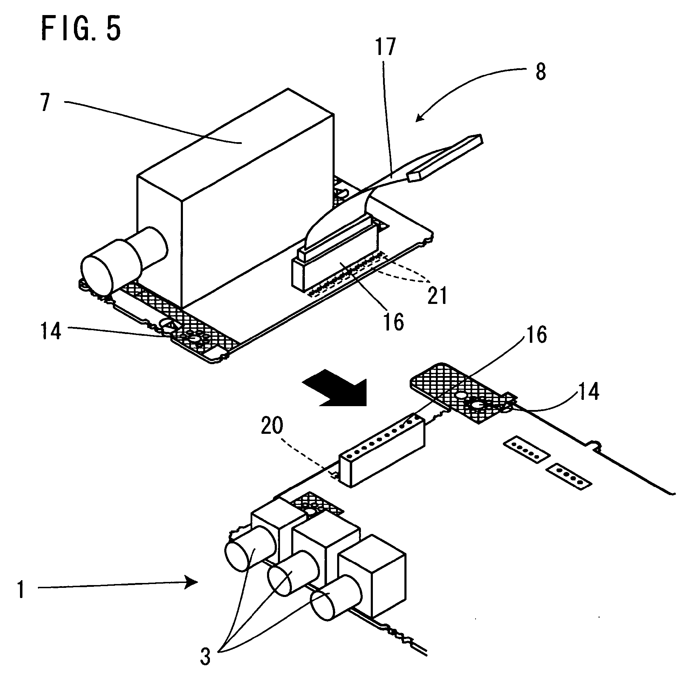

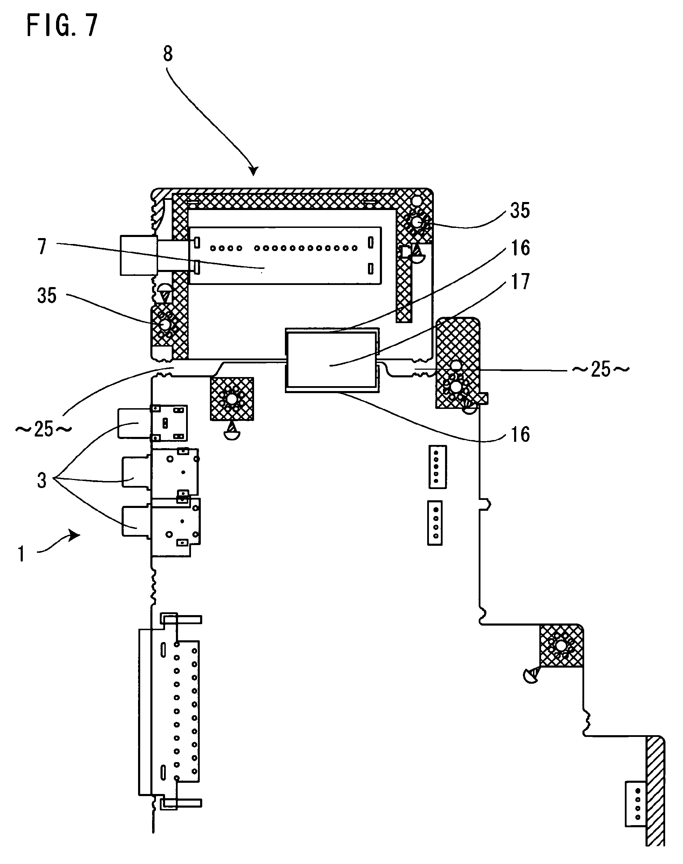

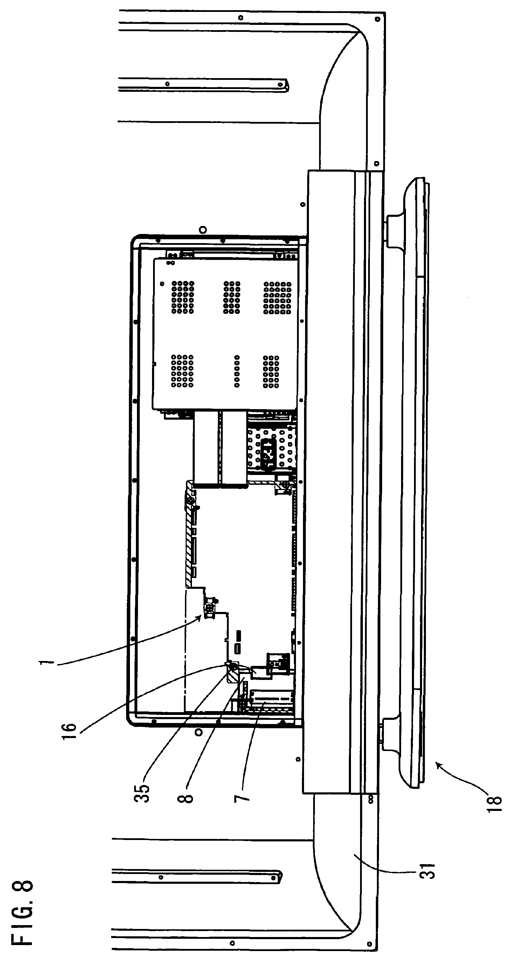

FIG. 1 to FIG. 8 are front views of a circuit substrate showing an embodiment of the present invention and with reference to these FIG. 1 to FIG. 8, the characteristic structure of the circuit substrate provided for electronic equipment of the present invention will be explained. This embodiment will explain a case where the present invention is applied to a circuit substrate housed in an enclosure of a television receiver. The circuit substrate is constructed of a main circuit substrate section 1 and a split substrate section 8, and a circuit pattern 2 made of copper foil or the like is formed in the main circuit substrate section 1 and split substrate section 8, and the circuit pattern 2 is covered with an insulating layer (not shown) except a connection section (not shown) where various electronic parts 3 are soldered. Furthermore, a split section 6 made up of grooves 5a and perforations 5b is formed on one side of the main circuit substrate section 1 and the split substrate section 8 on which a tuner 7 is mounted is formed in the area surrounded by this split section 6. In this embodiment, the split section 6 is formed in a channel shape close to one side edge of the split substrate section 8 and the split section 6 can be detached from the main circuit substrate section 1 as required. For example, when a circuit substrate is produced in the country and electronic equipment (a television receiver) is assembled in an overseas factory, the split substrate section 8 mounted with the tuner 7 is detached from the main circuit substrate section 1 and reconnected to the main circuit substrate section 1 in the overseas factory. In this case, the main circuit substrate section 1 and split substrate section 8 are connected using detachable connectors 16. Furthermore, when a circuit substrate is manufactured in the country and electronic equipment (a television receiver) is assembled in the country, the substrate section 8 is not detached from the main circuit substrate section 1 and left united. In this case, the main circuit substrate section 1 and split substrate section 8 are connected using jumper lines 10. That is, a circuit pattern 15 which is electrically connected to the tuner 7 is formed on the split substrate section 8, and circuit pattern 15 and the circuit pattern 2 formed on the above described circuit substrate section 1 are connected using the jumper lines 10 or connectors 16, the respective circuit patterns 2, 15 are provided with connection sections (land elements) 20, 21 as the common circuit patterns to allow the jumper lines 10 and connectors 16 to be commonly connected and insertion holes 22 of the jumper lines 10 and insertion holes 23 of connector terminals (not shown) are formed face to face in these connection sections 20, 21 respectively. Furthermore, two lines of grooves 5a making up the above split section 6 are formed in parallel on a boundary between the main circuit substrate section 1 and split substrate section 8 on which these connection sections 20, 21 are formed and the area surrounded by these two lines of grooves 5a and perforations 5b constitutes an expendable area 27 which can be detached.

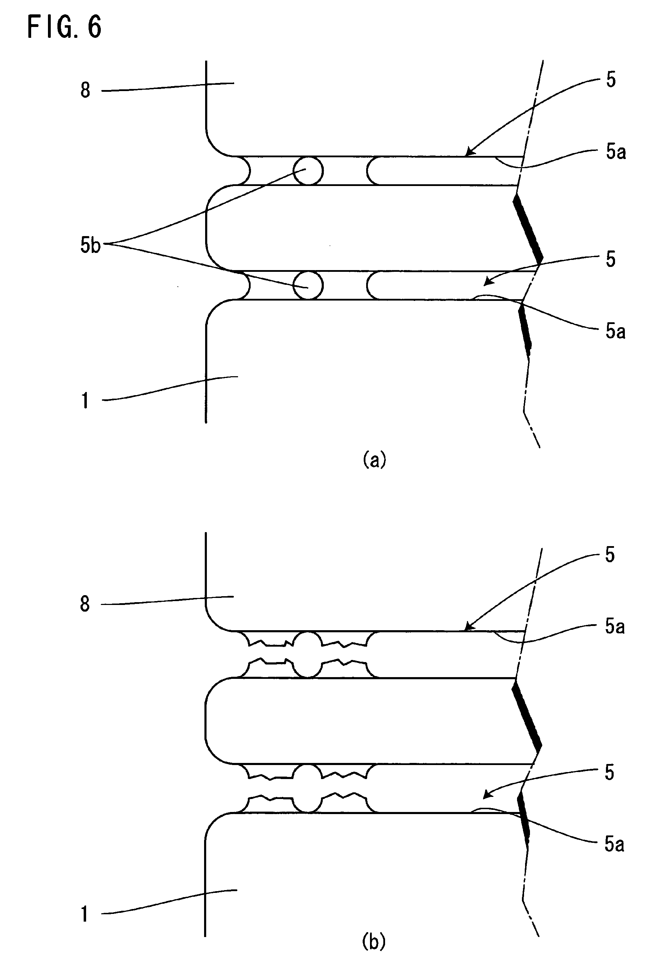

When, for example, the circuit substrate constructed as shown above is manufactured in the country and assembled into an enclosure 31 of a television receiver 30 in the country, the split substrate section 8 is not detached from the main circuit substrate section 1 and left united. In this case, both ends of the jumper lines 10 are inserted into the insertion holes 22 formed in the connection sections 20, 21 of the substrate sections 1, 8 and soldered to the connection sections 20, 21. In this way, the circuit patterns 2, 15 formed in the main circuit substrate section 1 and split substrate section 8 are electrically connected by the jumper lines 10 and the circuit pattern 2 formed in the main circuit substrate section 1 and the tuner 7 mounted on the split substrate section 8 are electrically connected. On the other hand, when, for example, a circuit substrate manufactured in the country is assembled into the enclosure 31 of the television receiver 30 overseas, the split substrate section 8 is detached from the main circuit substrate section 1 by means of the split section 6 formed in the main circuit substrate section 1. Connector terminals are inserted into the insertion holes 23 formed in the connection sections 20, 21 of the substrate sections 1, 8 and soldered to the connection sections 20, 21. The split substrate section 8 is placed in the original position of the main circuit substrate section 1, a connector cable 17 is connected to the connectors 16 attached to the substrate sections 1, 8 and the split substrate section 8 and main circuit substrate section 1 are electrically connected. The main circuit substrate section 1 and split substrate section 8 are fixed by screws (not shown) formed in the enclosure 31, but since there is no difference in the mounting position of the split substrate section 8 whether it is split or not, it goes without saying that screw holes 35 formed in the main circuit substrate section 1 and split substrate section 8 can be commonly used regardless of whether the split substrate section 8 is divided or not. Furthermore, when the split substrate section 8 is separated and mounted in the original position of the main circuit substrate section 1 again, two lines of grooves 5a and perforations 5b are formed in parallel as the split section 6 on the boundary between the main circuit substrate section 1 and split substrate section 8 where the connection sections 20, 21 are formed and the area surrounded by these two lines of grooves 5a and perforations 5b constitutes the expendable area 27 which can be detached, and therefore when the split substrate section 8 is placed in the original position, it is possible to avoid trouble that cut-out sections of the split section 6 interfere with each other. That is, as shown in FIG. 6, when the split substrate section 8 is separated in the part of the split section 6, irregular projections and depressions are produced in the cut-out sections divided by the split section 6 including the grooves 5a and perforations 5b, and when the split substrate section 8 is placed in the original position, it is difficult to align the cut-out section of the main circuit substrate section 1 with the cut-out section of the split substrate section 8, and when the split substrate section 8 is placed in the original position, a discrepancy may be easily produced between the cut-out sections. For this reason, the cut-out section of the split substrate section 8 and the cut-out section of the main circuit substrate section 1 interfere with each other, causing trouble in the mounting of the split substrate section 8. However, in this embodiment, the expendable area 27 is formed between the main circuit substrate section 1 and split substrate section 8, the expendable area 27 formed between the main circuit substrate section 1 and split substrate section 8 forms a wide space 25 between the main circuit substrate section 1 and split substrate section 8 and when the split substrate section 8 is placed in the original position, it is possible to prevent interference with the main circuit substrate section 1 and accurately and reliably place the split substrate section 8 in the original position. That is, the positional relation of the split substrate section 8 to the main circuit substrate section 1 remains the same regardless of whether the split substrate section 8 is divided or not.

In the above described embodiment, the split section 6 made up of the grooves 5a and perforations 5b is formed on one side of the main circuit substrate section 1 and the split substrate section 8 on which the tuner 7 is mounted is formed in the area surrounded by this split section 6, and when, for example, the circuit substrate is produced in the country and electronic equipment (a television receiver) is assembled in an overseas factory, the split substrate section 8 mounted with the tuner 7 is detached from the main circuit substrate section 1 and reconnected to the main circuit substrate section 1 through the connectors 16 in the overseas factory. In this way, it is possible to separate the split substrate section 8 mounted with the relatively high-profile tuner 7 from the main circuit substrate section 1 and transport the split substrate section 8 apart from the main circuit substrate section 1, thereby reduce time and trouble and transportation cost accompanying packing of the circuit substrate. On the other hand, when all steps from the manufacturing of the circuit substrate section 1 to assembly of the electronic equipment (television receiver 30) are performed in the country, the split substrate section 8 is not detached from the main circuit substrate section 1 and left united instead and the main circuit substrate section 1 and split substrate section 8 are connected by the jumper lines 10. Thus, depending on whether or not the split substrate section 8 is detached from the main circuit substrate section 1 as required, it is possible to select the connectors 16 or jumper lines 10 as the means for connecting the main circuit substrate section 1 and split substrate section 8. That is, the connection sections (land elements) 20, 21 where the jumper lines 10 and connectors 16 can be commonly connected are formed in the circuit patterns 2, 15 of the main circuit substrate section 1 and split substrate section 8 and even when any one of the connection means of the jumper lines 10 and connectors 16 is used, it is possible to connect the main circuit substrate section 1 and split substrate section 8. Furthermore, when the split substrate section 8 is detached from the main circuit substrate section 1 and placed in the original position and connected to the main circuit substrate section 1, it is possible to connect the main circuit substrate section 1 and split substrate section 8 using the detachable connectors 16, and thereby easily connect the main circuit substrate section 1 and split substrate section 8. Furthermore, two lines of grooves 5a making up the above described split section 6 are formed in parallel on the boundary between the main circuit substrate section 1 and split substrate section 8 in which the connection sections 20, 21 are formed, and the area surrounded by these two lines of grooves 5a and perforations 5b constitute the detachable expendable area 27, and therefore when the split substrate section 8 is separated and placed in the original again, the expendable area 27 forms a wide space 25 between the main circuit substrate section 1 and split substrate section 8, and therefore the cut-out section of the split substrate section 8 and the cut-out section of the main circuit substrate section 1 do not interfere with each other and it is possible to place the split substrate section 8 in the original position accurately and reliably. Regardless of whether the split substrate section 8 is divided or not, this makes it possible to achieve commonality of and eliminate the necessity for changing the construction on the enclosure 31 side in which the circuit substrate section 8 is assembled, that is, positions of the screw holes 35 formed in the split substrate section 8 and main circuit substrate section 1 and corresponding screw holes, positions of lead out holes to lead out the antenna terminal of the tuner 7, thus providing excellent versatility, improving the operational efficiency and reducing costs.

An embodiment of the present invention has been explained in detail so far, but the present invention is not limited to the above described one embodiment, and can be implemented modified in various forms without departing from the essence of the present invention. For example, the above described embodiment has shown an example of using a circuit substrate having a one-side structure, but double-side substrate or multilayered substrate may also be used. Furthermore, in the above described embodiment, the circuit substrate section 1 and split substrate 8 are connected using the jumper lines and connectors, but a jack or the like can also be used if they are electrically connected. Furthermore, the electronic part mounted on the split substrate is not limited to the tuner, and various types of electronic part may also be mounted. The television receiver has been illustrated as the electronic equipment but the present invention is not limited to this and is also applicable to various types of home electronic equipment.

The effects of the present invention are as follows.

The electronic equipment provided with a circuit substrate according to the first aspect is electronic equipment provided with a circuit substrate placed in an enclosure, on which an electronic part is mounted, the circuit substrate comprising a main circuit substrate section and a split substrate section which is detachable from the main circuit substrate section, wherein the split substrate section is made detachable from the main circuit substrate section as required, when the split substrate section is used united as the circuit substrate without being separated, the split substrate section and the main circuit substrate section are electrically connected using jumper lines, when the split substrate section is used detached from the main circuit substrate section, connectors which are freely attachable/detachable to/from the circuit substrate section and the split substrate section are inserted, both connectors are electrically connected by a cable, and the circuit substrate section and the split substrate section are provided with a circuit pattern common to the connectors and the jumper lines, and therefore when, for example, manufacturing and assembly of a substrate need to be performed in different factories, it is possible to reduce time and trouble and transportation cost accompanying packing of the circuit substrate by separating the split substrate section mounted with a dimensionally high-profile electronic part from the main circuit substrate section and simply and easily connect the electronic part mounted on the split substrate section and the main circuit substrate section through connectors when the split substrate section and the main circuit substrate section are connected. On the other hand, when all steps from manufacturing to assembly of the substrate are performed in the country, it is possible to realize electric connections with both substrates united using the jumper lines and thereby improve the operational efficiency.

The electronic equipment provided with a circuit substrate according to the second aspect is the electronic equipment provided with a circuit substrate according to the first aspect, wherein a split section made up of holes of perforations and grooves is formed on a boundary between the main circuit substrate section and split substrate section, a plurality of mutually facing split sections provided with at least the common circuit pattern arranged on the boundary between the main circuit substrate section and split substrate section are formed, and when the split substrate section is separated, a part surrounded by the facing split sections constitutes an expendable section which can be separated, and therefore it is possible to prevent interference that can be produced when irregular projections and depressions formed in the cut-out sections when the split substrate section is divided touch each other, place the split substrate section in the original position, regardless of whether the split substrate section is divided or not, it is possible achieve commonality of and eliminate the necessity for changing the construction on the enclosure side in which the circuit substrate is assembled, for example, positions of the screw holes formed in the split substrate section and main circuit substrate section and corresponding screw holes, positions of lead out holes of terminals of the electronic part mounted on the split substrate section, thus providing excellent versatility, improving the operational efficiency and reducing costs.

The electronic equipment provided with a circuit substrate according to the third aspect is the electronic equipment provided with a circuit substrate according to the first or second aspect, wherein the circuit substrate is placed in an enclosure of a television receiver, a tuner is mounted on the split substrate section as an electronic part, and the tuner is electrically connected to the circuit pattern of the main circuit substrate section through the jumper lines or connectors, and therefore it is possible to transport the split substrate section mounted with a relatively high-profile tuner and reduce the packing size when the split substrate section is used divided and thereby reduce transport costs, and it is possible to connect the substrates through the connectors when the split substrate section is separated and then connected and easily realize electric connections using the jumper lines when there is no need for separation, thus improving the operational efficiency.

## Claims

1. Electronic equipment provided with a circuit substrate placed in an enclosure, on which an electronic part is mounted, the circuit substrate comprising a main circuit substrate section and a split substrate section which is detachable from the main circuit substrate section,
wherein the split substrate section is made detachable from the main circuit substrate section as required, when the split substrate section is used united as the circuit substrate without being separated, the split substrate section and the main circuit substrate section are electrically connected using jumper lines, when the split substrate section is used detached from the main circuit substrate section, connectors which are freely attachable/detachable to/from the circuit substrate section and the split substrate section are inserted, both connectors are electrically connected by a cable, and the circuit substrate section and the split substrate section are provided with a circuit pattern common to the connectors and the jumper lines.

2. The electronic equipment provided with a circuit substrate according to claim 1, wherein a split section made up of holes of perforations and grooves is formed on a boundary between the main circuit substrate section and split substrate section, a plurality of mutually facing split sections provided with at least the common circuit pattern arranged on the boundary between the main circuit substrate section and split substrate section are formed, and when the split substrate section is separated, a part surrounded by the facing split sections constitutes an expendable section which can be separated.

3. The electronic equipment provided with a circuit substrate according to claim 1 or 2, wherein the circuit substrate is placed in an enclosure of a television receiver, a tuner is mounted on the split substrate section as an electronic part, and
the tuner is electrically connected to the circuit pattern of the main circuit substrate section through the jumper lines or connectors.
